# EUROPEAN PATENT APPLICATION

(11) **EP 4 411 385 A1**
(43) Date of publication of application: **07.08.2024**
(21) Application number: 22875823.1
(22) Date of filing: 13.09.2022
(51) Int. Cl.: G01N 35/08, B01J 19/00, B29C 65/52, B32B 3/26, B32B 37/12, B81B 1/00, B81C 1/00, C09J 123/00, G01N 37/00

(54) **LAMINATE AND METHOD FOR MANUFACTURING SAME**

(30) Priority: 30.09.2021 JP 2021161940
(71) Applicant: Zeon Corporation, Tokyo 100-8246 (JP)
(72) Inventor: CHIBA, Daido, Tokyo 100-8246 (JP); NISHIOKA, Hiroya, Tokyo 100-8246 (JP)
(74) Representative: Maiwald GmbH
(86) International application number: PCT/JP2022/034264
(87) International publication number: WO 2023/053952

(57) **Abstract**

Provided are a laminate that can be used as a microchannel chip that maintains joint strength while also displaying good external appearance and having reduced risk of liquid leakage from a channel and a method for manufacturing the same. The laminate includes a channel-equipped substrate having a cycloolefin polymer as a material and a cover material having a cycloolefin polymer as a material that are joined via a joining agent having a mixture of two or more cycloolefin polymers as a material. A glass-transition temperature of the mixture of cycloolefin polymers that is a material of the joining agent is not less than 20°C lower than both a glass-transition temperature of the cycloolefin polymer that is a material of the channel-equipped substrate and a glass-transition temperature of the cycloolefin polymer that is a material of the cover material and is not lower than 68°C and not higher than 138°C.

## Description

### TECHNICAL FIELD

The present disclosure relates to a laminate and a method for manufacturing the same.

### BACKGROUND

In recent years, chips (microchannel chips) having fine channels or reactors on the order of micrometers formed by microprocessing techniques have been used in various fields for analysis and testing of biological substances such as DNA, RNA, and proteins, drug discovery/pharmaceutical development, organic synthesis, water quality analysis, and so forth.

Moreover, microchannel chips made of resin that can be manufactured at low cost have been attracting attention.

A resin microchannel chip may be manufactured by providing a joining agent between a resin substrate having a microchannel formed on at least one surface thereof and a resin cover material serving as a lid material so as to join the resin substrate and the cover material. Patent Literature (PTL) 1 describes the manufacture of a resin microchannel chip by joining a substrate and a cover material via a joining agent, wherein a channel is formed in the substrate, a site with a protruding shape at an edge of the channel is formed on the cover material, and a groove for air release from the joining agent is formed in the substrate or the cover material. PTL 2 describes the manufacture of a resin microchannel chip by joining a substrate having a groove corresponding to a channel and a cover material having a protrusion corresponding to the groove via a joining agent that is selectively applied in a section other than a channel formation section. PTL 3 describes the manufacture of a resin microchannel chip by joining a substrate having a channel formed therein and a plastic film serving as a cover material via a joining agent and then reinforcing the substrate and the plastic film through thermal fusion.

### CITATION LIST

### Patent Literature

PTL 1: JP4752364B2
PTL 2: JP2015-064321A
PTL 3: JP2008-157644A

### SUMMARY

### (Technical Problem)

A microchannel chip that is manufactured using a cycloolefin polymer having transparency and low autofluorescence as a material of a substrate is advantageous for optically analyzing a subject inside of a channel with low noise because this limits the optical influence of the substrate. A joining agent other than a cycloolefin polymer has conventionally been used in order to achieve strong joining performance of substrates in such microchannel chips, and thus such microchannel chips have suffered from a problem of noise caused by autofluorescence of the joining agent material during optical signal detection. It is expected that were one able to use a cycloolefin polymer as a joining agent material so as to manufacture a microchannel chip in which every member is formed of a cycloolefin polymer, it would be possible to perform optical analysis of the microchannel chip with even lower noise.

In the case of such a microchannel chip, the use of a large amount of joining agent improves joint strength but results in poorer external appearance and increased risk of liquid leakage from a channel due to unevenness of the joint. Conversely, the use of a small amount of joining agent reduces joint strength and thus results in poorer external appearance and increased risk of liquid leakage from a channel due to looseness of the joint. Therefore, there is demand for a microchannel chip that maintains joint strength while also displaying good external appearance and having reduced risk of liquid leakage from a channel even when a cycloolefin polymer is used as a material for the entire microchannel chip.

Accordingly, an object of the present disclosure is to provide a laminate that can be used as a microchannel chip that maintains joint strength while also displaying good external appearance and having reduced risk of liquid leakage from a channel even when a cycloolefin polymer is used as a material of the entire microchannel chip and also to provide a method for manufacturing the same.

### (Solution to Problem)

As a result of diligent research aimed at solving the problem set forth above, the inventors discovered that by using, as a material of a joining agent, a mixture of two or more cycloolefin polymers that has a glass-transition temperature within a specific temperature range and for which temperature differences between the glass-transition temperature thereof and glass-transition temperatures of cycloolefin polymers serving as materials of a channel-equipped substrate and a cover material are within a specific range, and by depositing the joining agent such as to have an average roughness that is within a specific range and then performing affixing, it is possible to obtain a laminate that can be used as a microchannel chip that maintains joint strength while also displaying good external appearance and having reduced risk of liquid leakage from a channel. In this manner, the inventors completed the present disclosure.

Thus, the present disclosure provides the following laminate and methods for manufacturing the same.
{1} A laminate comprising:
   a channel-equipped substrate having a cycloolefin polymer as a material; and
   a cover material having a cycloolefin polymer as a material that are joined via a joining agent having a mixture of two or more cycloolefin polymers as a material,
   wherein a glass-transition temperature of the mixture of cycloolefin polymers that is a material of the joining agent is not less than 20°C lower than both a glass-transition temperature of the cycloolefin polymer that is a material of the channel-equipped substrate and a glass-transition temperature of the cycloolefin polymer that is a material of the cover material and
   wherein the glass-transition temperature of the mixture of cycloolefin polymers that is a material of the joining agent is not lower than 68°C and not higher than 138°C.
{2} A method for manufacturing the laminate according to the foregoing {1}, comprising:
   depositing a joining agent selectively in a specific region of either or both of a joining surface of a channel-equipped substrate and a joining surface of a cover material such as to have an uneven shape with an average roughness Ra of not less than 0.05 µm and not more than 0.80 µm; and
   joining the channel-equipped substrate and the cover material via the joining agent that has been deposited.
{3} The method according to the foregoing {2}, wherein, in the depositing of the joining agent, the joining agent is deposited on either or both of one surface of the channel-equipped substrate and one surface of the cover material by silk screen printing.

### (Advantageous Effect)

According to the present disclosure, it is possible to provide a laminate that can be used as a microchannel chip that maintains joint strength while also displaying good external appearance and having reduced risk of liquid leakage from a channel and also to provide a method for manufacturing the same.

### BRIEF DESCRIPTION OF THE DRAWINGS

In the accompanying drawings:
FIG. 1A is a photograph illustrating an example of external appearance of a presently disclosed laminate (microchannel chip) that displays good external appearance and has reduced risk of liquid leakage from a channel;
FIG. 1B is a photograph illustrating an example of external appearance of a laminate (microchannel chip) that is a defective product that has poor external appearance and may experience liquid leakage from a channel;
FIG. 2A illustrates an example of a layout of a channel-equipped substrate;
FIG. 2B illustrates an example of a layout of a cover material;
FIG. 3 is a schematic diagram illustrating an example of a method for manufacturing a presently disclosed laminate;
FIGS. 4A to 4C are conceptual diagrams for describing the effect that average roughness Ra of a joining agent has on a laminate, where FIG. 4A illustrates a case in which Ra is excessive, FIG. 4B illustrates a case in which Ra is appropriate, and FIG. 4C illustrates a case in which Ra is insufficient;
FIG. 5A illustrates a side view (top) and a plan view (bottom) of a joined product 20 for joint strength measurement that is used in joint strength measurement; and
FIG. 5B illustrates a schematic diagram of joint strength measurement.

### DETAILED DESCRIPTION

The following provides a detailed description of embodiments of the present disclosure.

### (Laminate)

A presently disclosed laminate includes a channel-equipped substrate having a cycloolefin polymer as a material and a cover material having a cycloolefin polymer as a material that are joined via a joining agent having a mixture of two or more cycloolefin polymers as a material, wherein a glass-transition temperature of the mixture of cycloolefin polymers that is a material of the joining agent is not less than 20°C lower than both a glass-transition temperature of the cycloolefin polymer that is a material of the channel-equipped substrate and a glass-transition temperature of the cycloolefin polymer that is a material of the cover material and is not lower than 68°C and not higher than 138°C.

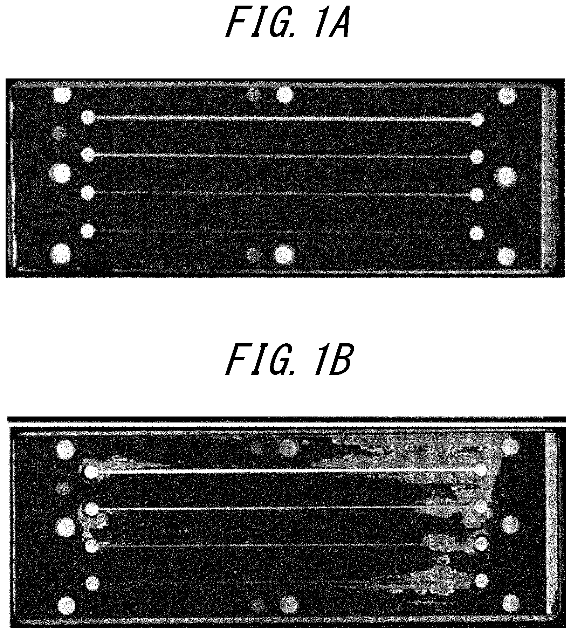

The presently disclosed laminate can be used as a microchannel chip, and particularly as a microchannel chip that is suitable for optical analysis of biological substances such as DNA, RNA, and proteins. Moreover, the presently disclosed laminate is suitable for optical analysis as a result of cycloolefin polymers having transparency and low autofluorescence being used as materials for the entirety of the laminate. Furthermore, as a result of the presently disclosed laminate having the features set forth above, the presently disclosed laminate can be used as a microchannel chip that maintains joint strength while also displaying good external appearance and having reduced risk of liquid leakage from a channel. An example of such external appearance is illustrated in FIG. 1A. The following describes each constituent element of the presently disclosed laminate.

Glass-transition temperatures referred to in the present disclosure can be measured by differential scanning calorimetry (DSC) based on JIS-K7121.

### <Channel-equipped substrate>

A substrate made of a cycloolefin polymer that has a microchannel formed on at least one surface thereof and that optionally has a through hole (injection/discharge through hole) connecting the channel to the outside for injection or discharge of a sample or the like can be used as the channel-equipped substrate. Moreover, the channel-equipped substrate may optionally have another recessed/protruding part or through hole. The other recessed/protruding part or through hole may, for example, be a fitting recessed/protruding part or through hole (knock pin) for positioning during joining, a recessed/protruding part that arises at an ejector pin position during mold release, or the like. The channel substrate is joined to the cover material with a surface at which the microchannel is formed as a joining surface.

The microchannel width, depth, and shape can be changed as appropriate depending on the application of the microchannel chip, but are normally on the order of millimeters or smaller, and are preferably on the order of micrometers, though they may even be on the order of nanometers. Specifically, the microchannel width can be set as not less than 10 µm and not more than 800 µm, for example, but is not specifically limited thereto.

The formation of a microchannel, an injection/discharge through hole, and/or another recessed/protruding part or through hole with respect to the substrate made of a cycloolefin polymer can be performed by a microprocessing technique such as photolithography or thermal imprinting, cutting, injection molding (injection molding in which substrate molding is also integrated), or the like, for example. Moreover, formation of a channel, an injection/discharge through hole, and/or another recessed/protruding part or through hole can be performed before or after deposition of the joining agent as appropriate.

### <Cover material>

Any substrate made of a cycloolefin polymer that can cover the microchannel formed on the channel-equipped substrate can be used as the cover material. Specifically, the cover material may be a substrate having a smooth surface that can cover the channel-equipped substrate and optionally having a through hole (injection/discharge through hole) that, when the cover material is used with the channel-equipped substrate to form a microchannel chip laminate, connects the channel of the channel-equipped substrate to the outside for injection or discharge of a sample or the like. Moreover, the cover material may optionally have another recessed/protruding part or through hole. The other recessed/protruding part or through hole may be a knock pin, a recessed/protruding part at an ejector pin position, or the like, for example. The cover material is joined to the channel substrate with the smooth surface side thereof as a joining surface. Note that the cover material may be a substrate having a microchannel formed at a surface at the opposite side thereof to the smooth surface side that is joined to the channel-equipped substrate.

The formation of an injection/discharge through hole and/or another recessed/protruding part or through hole with respect to the substrate made of a cycloolefin polymer can be performed by a microprocessing technique such as photolithography or thermal imprinting, cutting, injection molding (injection molding in which substrate molding is also integrated), or the like, for example. Moreover, formation of an injection/discharge through hole and/or another recessed/protruding part or through hole can be performed before or after deposition of the joining agent as appropriate.

### <Joining agent>

The joining agent is a material that is interposed between the channel-equipped substrate and the cover material and that joins the channel-equipped substrate and the cover material. A cycloolefin polymer is used as the joining agent from a viewpoint of suppressing noise caused by autofluorescence during optical signal detection. Moreover, a mixture of two or more cycloolefin polymers (hereinafter, referred to as a "cycloolefin polymer mixture") is used as the joining agent from a viewpoint of facilitating adjustment of the glass-transition temperature (Tg) of the joining agent to within a desired range as described further below. Although no specific limitations are placed on the types of cycloolefin polymers that are components of the cycloolefin polymer mixture, examples thereof include those given below.

### <<Glass-transition temperature of joining agent>>

The glass-transition temperature of the cycloolefin polymer mixture that is a material of the joining agent (hereinafter, referred to simply as the "glass-transition temperature of the joining agent") is a temperature that can be determined from the temperature of an inflection point of a DSC curve obtained when measurement is performed by differential scanning calorimetry (DSC) based on JIS-K7121. The glass-transition temperature is taken to be the inflection point temperature in a case in which there is only one inflection point and is taken to be the highest inflection point temperature in a case in which there is more than one inflection point. The glass-transition temperature of the joining agent is not less than 20°C lower, preferably not less than 30°C lower, and more preferably not less than 50°C lower than both the glass-transition temperature of the cycloolefin polymer forming the channel-equipped substrate (hereinafter, referred to simply as the "glass-transition temperature of the channel-equipped substrate") and the glass-transition temperature of the cycloolefin polymer forming the cover material (hereinafter, referred to simply as the "glass-transition temperature of the cover material"). When the glass-transition temperature of the joining agent satisfies the relationship set forth above, this means that by performing joining of the channel-equipped substrate and the cover material in manufacture of the laminate at a temperature that is higher than the glass-transition temperature of the joining agent but lower than both the glass-transition temperature of the channel-equipped substrate and the glass-transition temperature of the cover material, it is possible to cause softening of just the joining agent without softening, deformation, or deterioration of the channel-equipped substrate and the cover material, thereby enabling joining through thermal fusion.

The glass-transition temperature of the joining agent is 68°C or higher, preferably 80°C or higher, and more preferably 100°C or higher, and is 138°C or lower, preferably 130°C or lower, and more preferably 125°C or lower. When the glass-transition temperature of the joining agent is not lower than any of the lower limits set forth above, this results in good temperature stability of a joining layer. When the glass-transition temperature of the joining agent is not higher than any of the upper limits set forth above, this facilitates setting of a heating temperature for causing softening of just a joining layer in microchannel chip manufacture.

The glass-transition temperature of the cycloolefin polymer mixture can be adjusted as appropriate in accordance with the glass-transition temperature, mixing ratio, and so forth of the cycloolefin polymers that are components thereof. For example, the glass-transition temperature of the cycloolefin polymer mixture can be adjusted to a temperature within any of the ranges set forth above by producing the cycloolefin polymer mixture through mixing of a cycloolefin polymer having a glass-transition temperature of not lower than 58°C and not higher than 78°C and a cycloolefin polymer having a glass-transition temperature of not lower than 128°C and not higher than 148°C in an appropriately adjusted mixing ratio. A single cycloolefin polymer is normally designed within a specific glass-transition temperature range due to demand for improvement of performance stability, stability during melt processing, and molding accuracy. Therefore, in a situation in which a single cycloolefin polymer is used, it is necessary to adjust the temperature range in which processing such as joining is performed to within a glass-transition temperature range of the target cycloolefin polymer, which is highly restrictive. In contrast, the use of two or more cycloolefin polymers as a mixture enables adjustment of the cycloolefin polymer mixture to a desired glass-transition temperature range and enables suitable joining temperature design. Moreover, although a DSC curve obtained for the cycloolefin polymer mixture in the previously described glass-transition temperature measurement method may have a single inflection point or may have a plurality of inflection points, it is preferable that the DSC curve has a single inflection point from a viewpoint of suppressing deterioration of joint strength and external appearance caused by phase separation during heating.

### <<Form of deposition of joining agent>>

From a viewpoint of improving joint strength and external appearance and suppressing variation of optical characteristics of a channel section, it is preferable that the joining agent is selectively deposited in the entirety of a section other than the channel, injection/discharge through hole, and other recessed/protruding part or through hole.

The thickness of the deposited joining agent (total thickness in a case in which the joining agent is deposited on both a joining surface of the channel-equipped substrate and a joining surface of the cover material) may be 50 µm or less, preferably 40 µm or less, more preferably 10 µm or less, and even more preferably 5 µm or less, for example. A thinner thickness of deposited joining agent means that the joining agent is present as a thin film, which inhibits jutting out of the joining agent into a channel during microchannel chip lamination and channel deformation when steam sterilization treatment of the laminate is performed. The thickness of the deposited joining agent should be of a minimum thickness that makes it possible to ensure adhesiveness of the channel-equipped substrate and the cover material and may be 0.1 µm or more, preferably 0.12 µm or more, more preferably 0.15 µm or more, and even more preferably 0.2 µm or more, for example.

A ratio of the thickness of the deposited joining agent relative to the channel depth may be 0.1/100 or more, preferably 0.12/100 or more, more preferably 0.15/100 or more, and even more preferably 0.2/100 or more, for example. Moreover, the ratio of the thickness of the deposited joining agent relative to the channel depth may be 50/100 or less, preferably 30/100 or less, more preferably 20/100 or less, and even more preferably 10/100 or less, for example.

### <Materials of channel-equipped substrate, cover material, and joining agent>

Cycloolefin polymers are used as materials of the channel-equipped substrate, the cover material, and the joining agent. A cycloolefin polymer has little reduction of joint strength over time and reduction of optical stability due to water absorption, and thus is suitable for a microchannel chip having excellent durability. Moreover, a cycloolefin polymer is a material having transparency and low autofluorescence, and thus is suitable for detection of an optical signal from a microchannel of a microchannel chip. By using cycloolefin polymers as all materials of a microchannel chip and by not using an adhesive material such as an autofluorescent material, it is possible to suppress noise due to autofluorescence of an adhesive material during optical signal detection. The cycloolefin polymers used as materials of the channel-equipped substrate, the cover material, and the joining agent satisfy the previously described glass-transition temperature relationship. As a result of such a glass-transition temperature relationship being satisfied, it is possible to obtain a microchannel chip laminate that maintains joint strength of the channel-equipped substrate and the cover material while also displaying good external appearance and having reduced risk of liquid leakage from a channel even when cycloolefin polymers are used as all materials of the microchannel chip. The types of cycloolefin polymers used as materials of the channel-equipped substrate, the cover material, and the joining agent may be selected as appropriate from specific examples described further below, for example, such that the aforementioned glass-transition temperature relationship is satisfied. The cycloolefin polymers used as materials of the channel-equipped substrate, the cover material, and the joining agent are preferably cycloolefin polymers having a water absorption of 0.01 mass% or less. The cycloolefin polymers used as materials of the channel-equipped substrate and the cover material may be of the same type or may be of different types.

### «Types of cycloolefin polymers»

Each of the cycloolefin polymers may be a polymer or copolymer (hereafter, also referred to collectively using the term "polymer") that is obtained through polymerization of a monomer such as described below, or may be a hydrogenated product thereof, for example. The cycloolefin polymer may be crystalline or amorphous, but is preferably amorphous. It is preferable that a norbornene-based monomer is used as a monomer of the cycloolefin polymer. The norbornene-based monomer is a monomer having a norbornene ring. The norbornene-based monomer may be a bicyclic monomer such as bicyclo[2.2.1]hept-2-ene (commonly referred to as norbornene), 5-ethylidene-bicyclo[2.2.1]hept-2-ene (commonly referred to as ethylidene norbornene), or a derivative of either thereof (derivative having a substituent on a ring); a tricyclic monomer such as tricyclo[5.2.1.0^{2,6}]deca-3,8-diene (commonly referred to as dicyclopentadiene) or a derivative thereof; a tetracyclic monomer such as tetracyclo[7.4.0.0^{2,7}.1^{10,13}]tetradeca-2,4,6,11-tetraene (commonly referred to as methanotetrahydrofluorene), tetracyclo[6.2.1.1^{1,6}.0^{2,7}]dodec-4-ene (commonly referred to as tetracyclododecene), 9-ethylidenetetracyclo[6.2.1.1^{3,6}.0^{2,7}]dodec-4-ene, or a derivative of any thereof; or the like, for example. These monomers may have a substituent at any position. Examples of possible substituents include an alkyl group, an alkylene group, a vinyl group, an alkoxycarbonyl group, and an alkylidene group. The norbornene-based monomer may include two or more types of such substituents. Specific examples of derivatives include 8-methoxycarbonyl-tetracyclo[4.4.0.1^{2,5}.1^{7,10}]dodec-3-ene, 8-methyl-8-methoxycarbonyl-tetracyclo[4.4.0.1^{2,5}.1^{7,10}]dodec-3-ene, and 8-ethylidene-tetracyclo[4.4.0.1^{2,5}.1^{7,10}]dodec-3-ene (ethylidene tetracyclododecene, ETD). One of these norbornene-based monomers may be used individually, or two or more of these norbornene-based monomers may be used in combination. The cycloolefin polymer may be an addition polymer, a ring-opened polymer, or a hydrogenated product of either thereof, and is preferably a ring-opened polymer or a hydrogenated ring-opened polymer. In the case of a cycloolefin polymer that is used as a material of a substrate (channel-equipped substrate, cover material), it is preferable to use a polymer obtained through polymerization of monomer(s) among which the content of methanotetrahydrofluorene (MTF) is 25 parts by weight or more relative to 100 parts by weight, in total, of the monomer(s). The cycloolefin polymer mixture used as a material of the joining agent preferably includes at least a cycloolefin polymer obtained through polymerization of monomer(s) among which the content of dicyclopentadiene (DCPD) is 30 parts by weight or more relative to 100 parts by weight, in total, of the monomer(s).

The aforementioned ring-opened polymer can be produced by a method using a ring-opening polymerization catalyst. A catalyst comprising a halide of a metal such as ruthenium or osmium, a nitrate or acetylacetone compound, and a reductant; or a catalyst comprising a halide of a metal such as titanium, zirconium, tungsten, or molybdenum or acetylacetone compound and an organoaluminum compound, for example, can be used as the ring-opening polymerization catalyst. The ring-opened polymer can be produced by a method using a metathesis reaction catalyst (ring-opening polymerization catalyst) such as a ruthenium carbene complex catalyst described in WO2010/110323A1, a method using a ring-opening polymerization catalyst such as a tungsten(phenylimide)tetrachloride tetrahydrofuran complex or tungsten hexachloride described in JP2015-54885A, or the like, for example.

The aforementioned addition polymer can be obtained by polymerizing monomer(s) using a commonly known addition polymerization catalyst such as a catalyst comprising a titanium, zirconium, or vanadium compound and an organoaluminum compound. The addition polymer can be produced by, for example, performing addition copolymerization of a monomer of a cycloolefin polymer and, as necessary, a monomer (other monomer) that can be addition copolymerized, in the presence of a metallocene catalyst described in WO2017/199980A1.

Examples of other monomers that can be ring-opening copolymerized with a norbornene-based monomer include cycloolefin-based monomers that are monocyclic such as cyclohexene, cycloheptene, and cyclooctene.

One of these other monomers that can be ring-opening copolymerized with a norbornene-based monomer may be used individually, or two or more of these other monomers that can be ring-opening copolymerized with a norbornene-based monomer may be used in combination. In a case in which a norbornene-based monomer is ring-opening copolymerized with another monomer that can be ring-opening copolymerized therewith, appropriate selection is made such that, in the ring-opened polymer, the proportions of structural units derived from the norbornene-based monomer and structural units derived from the other monomer that can be ring-opening copolymerized are, as a weight ratio, normally within a range of 70:30 to 99:1, preferably within a range of 80:20 to 99:1, and more preferably within a range of 90:10 to 99:1.

Examples of other monomers that can be addition copolymerized with a norbornene-based monomer include α-olefins having a carbon number of 2 to 20 such as ethylene, propylene, 1-butene, 1-pentene, and 1-hexene, and derivatives thereof; cycloolefins such as cyclobutene, cyclopentene, cyclohexene, cyclooctene, and 3a,5,6,7a-tetrahydro-4,7-methano-1H-indene, and derivatives thereof; and non-conjugated dienes such as 1,4-hexadiene, 4-methyl-1,4-hexadiene, 5-methyl-1,4-hexadiene, and 1,7-octadiene. Of these other monomers, α-olefins are preferable, and ethylene is particularly preferable.

One of these other monomers that can be addition copolymerized with a norbornene-based monomer may be used individually, or two or more of these other monomers that can be addition copolymerized with a norbornene-based monomer may be used in combination. In a case in which a norbornene-based monomer is addition copolymerized with another monomer that can be addition copolymerized therewith, appropriate selection is made such that, in the addition polymer, the proportions of structural units derived from the norbornene-based monomer and structural units derived from the other monomer that can be addition copolymerized are, as a weight ratio, normally within a range of 30:70 to 99:1, preferably within a range of 50:50 to 97:3, and more preferably within a range of 70:30 to 95:5.

Moreover, the method by which a hydrogenated alicyclic structure-containing ring-opened polymer is produced through hydrogenation of a ring-opened polymer may be a method using a hydrogenation catalyst described in WO2010/110323A1, or the like, for example. For example, a hydrogenated alicyclic structure-containing ring-opened polymer can be produced by using a ruthenium carbene complex catalyst such as described above as a ring-opening polymerization catalyst in order to produce an alicyclic structure-containing polymer and then also using the ruthenium carbene catalyst in that form as a hydrogenation catalyst in order to hydrogenate the alicyclic structure-containing ring-opened polymer.

The glass-transition temperature (Tg) of a cycloolefin polymer can be adjusted as appropriate in accordance with the type(s) and mixing ratio of monomer(s) used in polymerization, the average molecular weight and molecular weight distribution of the polymer, and so forth.

In the presently disclosed laminate, one or more of the channel-equipped substrate, the cover material, and the joining agent may include two or more layers of differing Tg (however, each Tg satisfies the previously described relationship).

### (Method for manufacturing laminate)

The presently disclosed laminate can be manufactured by the method described below (hereinafter, referred to as the "presently disclosed method"), for example.

The presently disclosed method includes:
a step of depositing a joining agent selectively in a specific region of either or both of a joining surface of a channel-equipped substrate and a joining surface of a cover material such as to have an uneven shape with an average roughness Ra of not less than 0.05 µm and not more than 0.80 µm; and
a step of joining the channel-equipped substrate and the cover material via the joining agent that has been deposited.
Moreover, the presently disclosed method may further include other steps. The channel-equipped substrate, cover material, and joining agent that were previously described can be used as the channel-equipped substrate, cover material, and joining agent in the presently disclosed method. As a result of the presently disclosed method having the features set forth above, the presently disclosed method enables the manufacture of a laminate that can be used as a microchannel chip that maintains joint strength while also displaying good external appearance and having reduced risk of liquid leakage from a channel. The following describes each step of the presently disclosed method.

### <Joining agent deposition step>

In the joining agent deposition step, the joining agent is deposited selectively in a specific region of either or both of a joining surface of the channel-equipped substrate and a joining surface of the cover material. "Deposited selectively in a specific region" means deposited in the entirety of a specific region and not deposited in regions other than the specific region. The term "specific region" refers to a continuous region that excludes, from the joining surface of the channel-equipped substrate or the cover material, recessed parts (channels, knock pins, ejector pin positions, etc.), protruding parts (knock pins, etc.), penetrating parts (through holes, etc.), and regions facing these parts when joining is performed, for example. By depositing the joining agent selectively in the specific region, it is possible to suppress variation of optical characteristics in a channel caused by the joining agent and also to suppress deterioration of external appearance and risk of liquid leakage from a channel due to uneven joining.

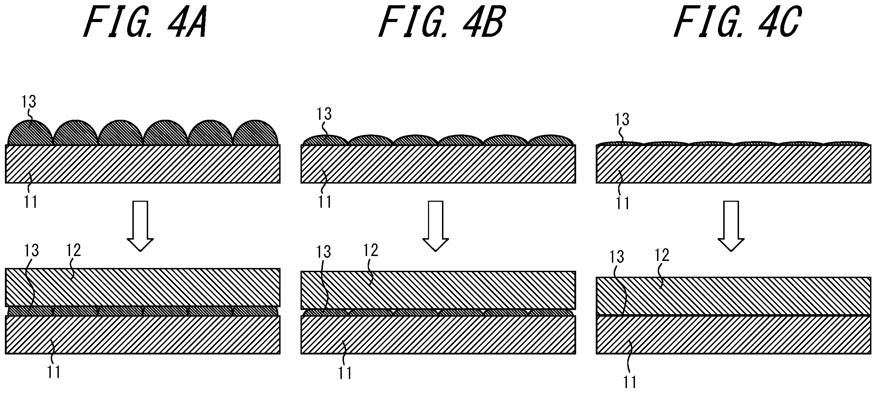

The average roughness Ra of the deposited joining agent is 0.05 µm or more, preferably 0.1 µm or more, and more preferably 0.2 µm or more, and is 0.80 µm or less, preferably 0.6 µm or less, and more preferably 0.4 µm or less. When the average roughness Ra of the joining agent is more than any of the upper limits set forth above, the amount of the joining agent that is applied becomes excessive, which increases the likelihood of deterioration of external appearance and leakage of liquid from a channel occurring due to unevenness of the joint (conceptual diagram of FIG. 4A). Moreover, when the average roughness Ra of the joining agent is less than any of the lower limits set forth above, the amount of the joining agent that is applied becomes insufficient, reduction of joint strength is more likely to occur, and there is also increased likelihood of deterioration of external appearance and leakage of liquid from a channel occurring due to looseness of the joint (conceptual diagram of FIG. 4C). On the other hand, when the average roughness Ra of the joining agent is within any of the ranges set forth above, an appropriate amount of the joining agent is applied, there is good joint strength, and unevenness and looseness of the joint are inhibited such that good external appearance is displayed and the risk of liquid leakage is reduced (conceptual diagram of FIG. 4B). The average roughness Ra of the joining agent can be measured by a method described in the EXAMPLES section, for example.

The joining agent deposition step can be performed by applying a joining agent that has been dissolved in a solvent selectively in the specific region and then causing evaporation of the solvent. Note that in the present specification, the term "dissolved" is inclusive of "dispersed" and the term "solvent" is inclusive of "dispersion medium".

### <<Dissolution of joining agent>>

The joining agent may be dissolved in a solvent in order to facilitate deposition by application. The solvent is not specifically limited so long as it is a solvent that can dissolve the cycloolefin polymer mixture that is a material of the joining agent and that can easily be removed by evaporation. Examples of such solvents include organic solvents such as cyclohexane, tetrahydrofuran, toluene, xylene, decalin, methylcyclohexane, and ethylcyclohexane. Any these solvents may be used as a mixed solvent. From a viewpoint of enabling adjustment of the average roughness Ra of the joining agent to within any of the ranges set forth above, the dissolved concentration of the joining agent (wt% of joining agent relative to total amount of joining agent and solvent) may be 1.0 wt% or more, preferably 5.0 wt% or more, and more preferably 10.0 wt% or more, for example, and may be 40.0 wt% or less, preferably 30.0 wt% or less, and more preferably 20.0 wt% or less, for example. When the dissolved concentration of the joining agent is more than any of the upper limits set forth above, the amount of the joining agent that is applied becomes excessive, which makes it more likely that the average roughness Ra of the joining agent will be excessively large and increases the likelihood of deterioration of external appearance and leakage of liquid from a channel occurring due to unevenness of the joint. When the dissolved concentration of the joining agent is less than any of the lower limits set forth above, the amount of the joining agent that is applied becomes insufficient, which makes it more likely that the average roughness Ra of the joining agent will be too small, increases the likelihood of reduction of joint strength, and also increases the likelihood of deterioration of external appearance and leakage of liquid from a channel occurring due to looseness of the joint.

### <<Application of joining agent>>

The joining agent is selectively applied in the specific region. The method of application is not specifically limited so long as it is a method that enables pattern application and may be silk screen printing, Mayer bar coating, or spray coating with masking, for example. Silk screen printing is preferable from a viewpoint of enabling adjustment of the average roughness Ra of the joining agent to within any of the ranges set forth above.

With regards to conditions that enable adjustment of the average roughness Ra of the joining agent to within any of the ranges set forth above in a case in which application of the joining agent is performed by silk screen printing, the mesh count of a screen mesh (mesh count per 1 inch (25.4 mm)) may be 100 or more, preferably 200 or more, and more preferably 250 or more, for example, and may be 1,000 or less, preferably 800 or less, and more preferably 650 or less, for example. When the mesh count is not less than any of the lower limits set forth above, it is possible to inhibit reduction of joint strength due to the amount of the joining agent that is applied being too small. Moreover, when the mesh count is not more than any of the upper limits set forth above, the amount of the joining agent that is applied is not excessive, and excessively large unevenness due to the mesh can be avoided.

The thread diameter of the screen mesh may be 1 µm or more, preferably 10 µm or more, and more preferably 15 µm or more, for example, and may be 200 µm or less, preferably 100 µm or less, and more preferably 50 µm or less, for example. When the thread diameter is not less than any of the lower limits set forth above, a sufficient amount of application and good leveling can be maintained. Moreover, when the thread diameter is not more than any of the upper limits set forth above, excessive application can be suppressed.

The material of the screen mesh may be metal (stainless steel, etc.), synthetic fiber (nylon, polyester, etc.), or natural fiber (silk, etc.), for example, but is preferably a metal that is a high strength material from a viewpoint of uniformly adjusting Ra to within a desired range. The metal surface may be subjected to fluorine coating as appropriate in order to improve transferability.

### <<Removal of solvent by evaporation>>

In a case in which the joining agent is dissolved in a solvent, the solvent is removed by evaporation after application of the joining agent. The evaporation of the solvent may, for example, be performed through drying (for example, heated drying or room temperature drying), heated vacuum (reduced pressure) drying, or a combination thereof at a lower temperature than the glass-transition temperature of the cycloolefin polymer mixture that is a material of the joining agent.

### <Channel-equipped substrate and cover material joining step>

The step of joining the channel-equipped substrate and the cover material may be performed through thermal fusion via the joining agent, for example. The thermal fusion is performed by stacking the channel-equipped substrate and the cover material with the joining agent in-between to form a temporarily-fixed joined product, and then heating the temporarily-fixed joined product at a temperature that is higher than the glass-transition temperature of the joining agent and lower than the glass-transition temperature of the channel-equipped substrate and the glass-transition temperature of the cover material. The means by which thermal fusion is performed may be autoclaving, hot pressing, roll pressing, or the like, for example. The temperature at which thermal fusion is performed is preferably not less than 5°C higher than the glass-transition temperature of the joining agent, and more preferably not less than 10°C higher than the glass-transition temperature of the joining agent. Moreover, the temperature at which thermal fusion is performed is preferably not more than 50°C higher than the glass-transition temperature of the joining agent, and more preferably not more than 40°C higher than the glass-transition temperature of the joining agent. Furthermore, from a viewpoint of preventing deformation of the channel-equipped substrate and the cover material, the temperature at which thermal fusion is performed is preferably not less than 5°C lower than a lowest temperature among the glass-transition temperatures of the channel-equipped substrate and the cover material, and more preferably not less than 10°C lower than the lowest temperature among the glass-transition temperatures of the channel-equipped substrate and the cover material. The thermal fusion may be performed while performing reduced pressure or vacuum degassing in order to prevent the inclusion of air bubbles.

### <Other steps>

Examples of other steps that may be further included in the presently disclosed method include a step of forming a microchannel, a through hole (injection/discharge through hole), and/or another recessed/protruding part or through hole at one or both surfaces of a substrate prior to the joining agent deposition step so as to form the channel-equipped substrate, a step of forming a through hole (injection/discharge through hole) and/or another recessed/protruding part or through hole in the cover material prior to the joining agent deposition step, and a step of embedding or setting a drug, electrode, or the like in an inner part.

### <Example of presently disclosed method>

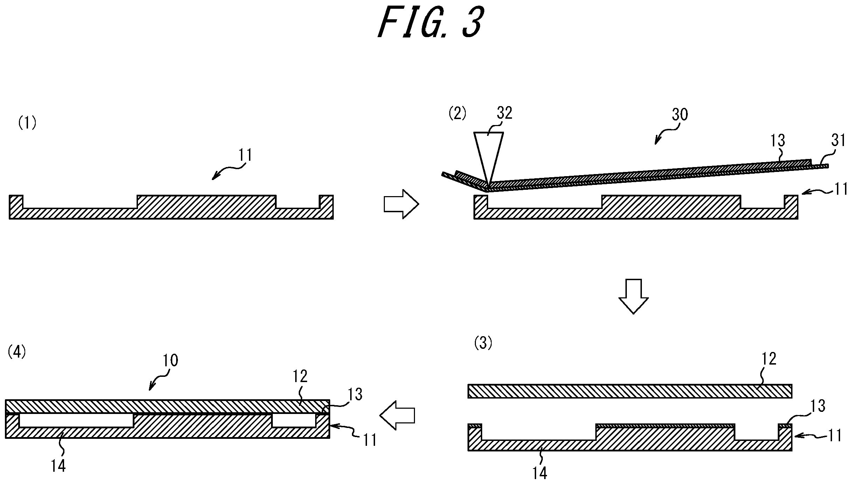

An example of the presently disclosed method is illustrated by a schematic diagram in FIG. 3. (1) in FIG. 3 illustrates a step of forming a channel 14 at a joining surface of a substrate to form a channel-equipped substrate 11. Formation of the channel 14 can be performed by cutting or injection molding, for example. (2) in FIG. 3 illustrates a step of depositing (applying) a joining agent 13 selectively in a specific region (pattern) at a channel formation surface of the channel-equipped substrate 11. This schematic diagram illustrates a case in which the step is performed by silk screen printing. (3) in FIG. 3 illustrates a step of stacking a cover material 12 on the channel-equipped substrate 11 onto which the joining agent 13 has been deposited (applied) and joining the cover material 12 to the channel-equipped substrate 11 through heating and pressing. (4) in FIG. 3 illustrates a completed product of a laminate 10 (microchannel chip) obtained through the steps described above.

### EXAMPLES

The following provides a more specific description of the present disclosure based on examples. However, the present disclosure is not limited to the following examples.

### <Methods for measuring and evaluating physical properties>

Measurements and evaluations of various physical properties were performed according to the following methods.

### (Method for measuring weight-average molecular weight Mw)

Weight-average molecular weight Mw was determined as a standard polyisoprene-equivalent value through measurement by gel permeation chromatography (GPC) with cyclohexane as an eluent. Standard polyisoprene produced by Tosoh Corporation was used as the standard polyisoprene. In a case in which the sample did not dissolve in cyclohexane, weight-average molecular weight Mw was determined as a standard polystyrene-equivalent value through measurement by GPC with tetrahydrofuran (THF) as an eluent. Standard polystyrene produced by Tosoh Corporation was used as the standard polystyrene.

### (Method for measuring glass-transition temperature)

Glass-transition temperature (Tg) was determined from the temperature of an inflection point of a DSC curve obtained by using a differential scanning calorimeter (DCS7000X produced by Hitachi, Ltd.) to perform measurement based on JIS-K7121 with a heating rate of 10°C/min.

### (Surface roughness)

The arithmetic average roughness Ra of a surface of a screen coated substrate was determined in accordance with JIS B 0601:2013 using a contact-type surface roughness measuring instrument (Surfcorder SE300 produced by Kosaka Laboratory Ltd.).

### (Surface observation)

A laser microscope OPTELICS MC-2000 produced by Lasertec Corporation was used to observe a joined chip in reflection mode with a ×5 objective lens (observation examples are illustrated as examples of external appearance in FIGS. 1A and 1B). Joined sections appear black, whereas non-joined sections such as channel sections appear white. Joining was judged to be good (OK) in a case in which sections other than channel and through hole pattern sections appeared black, such as in the example of external appearance in FIG. 1A. On the other hand, a section where there is deficient joining appears as a color close to white due to slight looseness of that section. Joining was judged to be deficient (Poor) in a case in which a section other than a channel and through hole pattern section appeared white, such as in the example of external appearance in FIG. 1B.

### (Joint strength)

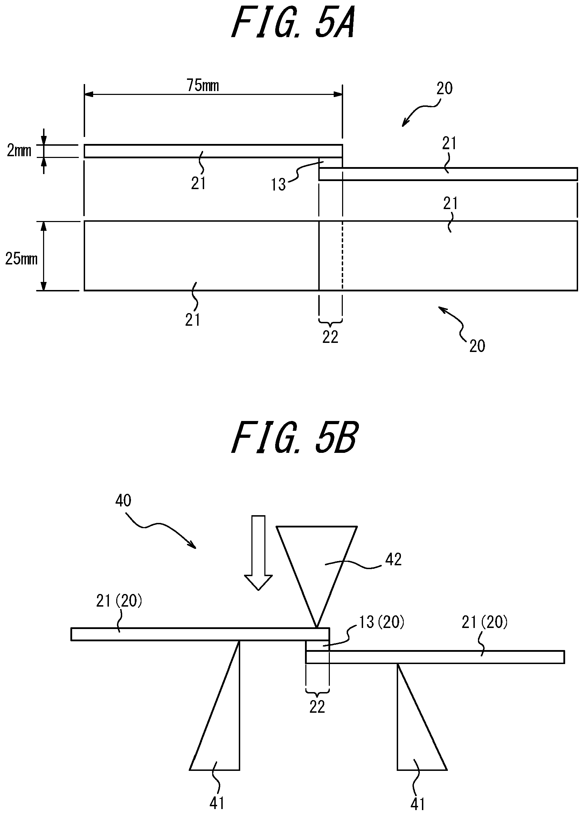

A joined product 20 for joint strength measurement such as illustrated in FIG. 5A was produced according to a subsequently described production method. This joined product 20 for joint strength measurement was set on two supporting points 41 of a material tester 40, and a central part (overlap margin 22) thereof was pressed from above by a pressing jig 42 as illustrated in FIG. 5B to perform a three-point flexural pressing test. The three-point flexural jig was set up in a universal testing machine (Instron 5582 produced by Instron Corporation) and was pressed with a distance between supporting points of 38 mm and a pressing rate of 10 mm/min to determine the strength at breaking (joint strength) using a tension/compression load cell (capacity ± 100 kN).

### [1. Production of cycloolefin polymers (COPs)]

### <Production of COP-1>

### (1-1) Production of ring-opened polymer

At room temperature, 200 parts by weight of dehydrated cyclohexane, 0.75 mol% of 1-hexene, 0.15 mol% of diisopropyl ether, and 0.44 mol% of triisobutylaluminum relative to 100 parts by weight, in total, of subsequently described monomers were loaded into a glass reactor that had been internally purged with nitrogen and were mixed. Thereafter, 28 parts by weight of methanotetrahydrofluorene (MTF), 35 parts by weight of tetracyclododecene (TCD), and 37 parts by weight of dicyclopentadiene (DCPD) as monomers and 0.02 mol% of tungsten hexachloride (0.65 weight% toluene solution) were continuously added into the reactor over 2 hours, concurrently to one another, and polymerization was performed while maintaining a temperature of 45°C. Next, 0.2 mol% of isopropyl alcohol was added to the polymerization solution so as to deactivate the polymerization catalyst and stop the polymerization reaction. Note that amounts given in units of "mol%" in the preceding description are each a value for when the total amount of monomers is taken to be 100 mol%. The resultant norbornene-based ring-opened polymer had a weight-average molecular weight (Mw) of 2.8 × 10⁴, a number-average molecular weight (Mn) of 1.3 × 10⁴, and a molecular weight distribution (Mw/Mn) of 2.1. The conversion rate of monomers to polymer was 100%.

### (1-2) Production of norbornene-based cycloolefin polymer (COP-1) by hydrogenation

Next, 300 parts by weight of a reaction solution containing the ring-opened polymer obtained by step (1-1) was transferred to a stirrer-equipped autoclave, 3 parts by weight of nickel catalyst loaded on diatomaceous earth (T8400RL produced by JGC C&C; nickel loading rate: 57%) was added, and a hydrogenation reaction was performed through 4 hours of autoclaving at a hydrogen pressure of 4.5 MPa and a temperature of 160°C.

Once the hydrogenation reaction had ended, the resultant solution was subjected to pressurized filtering (FUNDABAC Filter produced by Ishikawajima-Harima Heavy Industries Co., Ltd.) at a pressure of 0.25 MPa using Radiolite #500 as a filter bed so as to remove the hydrogenation catalyst and thereby obtain a colorless and transparent solution. The obtained solution was poured into a large amount of isopropanol to cause precipitation of a norbornene-based cycloolefin polymer (COP-1) as a hydrogenated ring-opened polymer. The norbornene-based cycloolefin polymer (COP-1) that precipitated was collected by filtration and was subsequently dried by a vacuum dryer (220°C, 1 Torr) for 6 hours to yield the norbornene-based cycloolefin polymer (COP-1). The norbornene-based cycloolefin polymer (COP-1) had a weight-average molecular weight (Mw) of 3.3 × 10⁴, a number-average molecular weight (Mn) of 1.5 × 10⁴, and a molecular weight distribution (Mw/Mn) of 2.2.

The glass-transition temperature Tg of the obtained norbornene-based cycloolefin polymer (COP-1) was 136°C.

The norbornene-based cycloolefin polymer (COP-1) obtained in step (1-2) was loaded into a twin-screw extruder and was molded into the form of a strand-like molded product by hot-melt extrusion. This molded product was finely cut using a strand cutter to obtain pellets of a thermoplastic norbornene-based resin that contained the norbornene-based cycloolefin polymer (COP-1).

### <Production of COP-2>

A norbornene-based cycloolefin polymer (COP-2) and pellets of a thermoplastic norbornene-based resin containing the COP-2 were obtained in the same way as in production of COP-1 with the exception that 60 parts by weight of methanotetrahydrofluorene (MTF) and 40 parts by weight of tetracyclododecene (TCD) were used as monomers. The COP-2 obtained through hydrogenation had a weight-average molecular weight (Mw) of 3.2 × 10⁴, a number-average molecular weight (Mn) of 1.9 × 10⁴, a molecular weight distribution (Mw/Mn) of 1.7, and a glass-transition temperature Tg of 163°C.

### <Production of COP-3>

A norbornene-based cycloolefin polymer (COP-3) and pellets of a thermoplastic norbornene-based resin containing the COP-3 were obtained in the same way as in production of COP-1 with the exception that 31 parts by weight of tetracyclododecene (TCD), 33 parts by weight of dicyclopentadiene (DCPD), and 36 parts by weight of norbornene (NB) were used as monomers. The COP-3 obtained through hydrogenation had a weight-average molecular weight (Mw) of 4.1 × 10⁴, a number-average molecular weight (Mn) of 1.3 × 10⁴, a molecular weight distribution (Mw/Mn) of 3.2, and a glass-transition temperature Tg of 68°C.

### <Production of COP-4>

A norbornene-based cycloolefin polymer (COP-4) and pellets of a thermoplastic norbornene-based resin containing the COP-4 were obtained in the same way as in production of COP-1 with the exception that 100 parts by weight of ethylidene tetracyclododecene (ETD) was used as a monomer. The COP-4 obtained through hydrogenation had a weight-average molecular weight (Mw) of 4.0 × 10⁴, a number-average molecular weight (Mn) of 1.9 × 10⁴, a molecular weight distribution (Mw/Mn) of 2.1, and a glass-transition temperature Tg of 138°C.

### [2. Production of test plate for joint strength measurement and cover material]

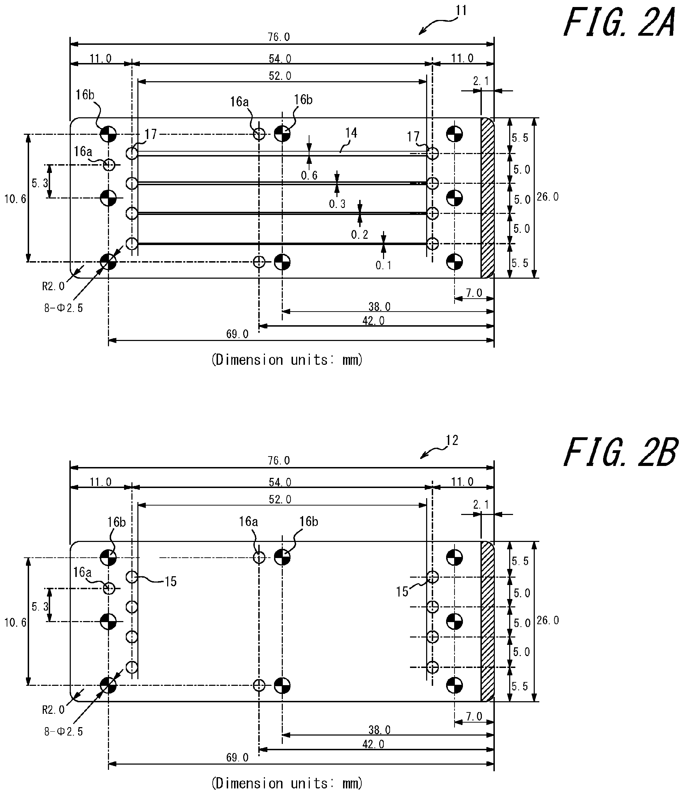

A mold for 2 mm (thickness) × 25 mm × 75 mm (four corners rounded with R2.0 mm) was installed in an injection molding machine (ROBOSHOT S2000i100A produced by FANUC Corporation), and cycloolefin polymer resin pellets obtained as described above were injection molded with a mold temperature of 80°C and a barrel temperature of 270°C in the case of COP-1 and with a mold temperature of 100°C and a barrel temperature of 290°C in the case of COP-2 to produce a test plate for joint strength measurement (smooth plate). In addition, a mold having a pattern of injection/discharge through holes 15, knock pins 16a (protruding parts), and ejector pin positions 16b illustrated in FIG. 2B was used to perform injection molding of cycloolefin polymer resin pellets in the same manner to produce a cover material.

### [3. Production of channel-equipped substrate]

A four-channel pattern mold was installed in an injection molding machine (ROBOSHOT S2000i100A produced by FANUC Corporation), and cycloolefin polymer resin pellets obtained as described above were injection molded with a mold temperature of 80°C and a barrel temperature of 270°C in the case of COP-1 and with a mold temperature of 100°C and a barrel temperature of 290°C in the case of COP-2 to produce a channel-equipped substrate of 2 mm (thickness) × 25 mm × 75 mm (four corners rounded with R2.0 mm) that had a pattern of channels 14, channel terminals 17, knock pins 16a (recessed parts), and ejector pin positions 16b illustrated in FIG. 2A.

### [4. Production of coating solution for joining layer formation]

A solvent and cycloolefin polymer resin pellets obtained as described above were measured into a hermetic vessel in a mixing ratio indicated in Table 1. The vessel was hermetically sealed and was then shaken by a shaker (MMS-1020 produced by Tokyo Rikakiki Co., Ltd.) at 25°C and 100 rpm for 6 hours to cause dissolution. After dissolution, the solution was filtered, and the filtrate was collected as a coating solution for joining layer formation. A portion of each coating solution for joining layer formation was collected for glass-transition temperature Tg measurement, the collected solution was air dried and subsequently dried by a vacuum dryer (140°C, 10 Torr) for 12 hours, and the glass-transition temperature Tg of the resultant joining agent solid matter was measured. The glass-transition temperature Tg of each joining agent is shown in Table 1.

### [5. Deposition of joining agent]

### (5-1. Joining agent deposition region)

For evaluation of external appearance, the entirety of a section other than a pattern section of channels, etc. at the channel formation surface of the channel-equipped substrate was taken to be a joining agent deposition region. For measurement of joint strength, the entirety of a region (overlap margin) up to 5 mm from the end of a short side at one surface of the test plate for joint strength measurement was taken to be a joining agent deposition region. The joining agent deposition region of each of the channel-equipped substrate and the test plate for joint strength measurement was coated with the coating solution for joining layer formation and was dried so as to form a joining layer in that region. Coating was performed by screen coating in Examples 1 to 4 and Comparative Example 1 and was performed by Mayer bar coating in Comparative Examples 2 and 3. The thickness of the joining layer is shown in Table 1.

### (5-1-1. Screen coating)

In Examples 1 to 4 and Comparative Example 1, an SUS #500 mesh screen (produced by SONOCOM Co., Ltd.) or a nylon mesh screen (Digital Screen Master produced by Riso Kagaku Corporation) that had a mesh count and a thread diameter shown in Table 1 and that was masked with a specific pattern was installed in a silk printing machine (HP-320 produced by Newlong Seimitsu Kogyo Co., Ltd.), and screen coating was performed so as to coat the coating solution for joining layer formation onto a plate (channel-equipped substrate and test plate for joint strength measurement). The coated plate was placed in an oven of a designated temperature and was dried to form a joining layer.

### (5-1-2. Mayer bar coating)

In Comparative Examples 2 and 3, the coating solution for joining layer formation was dripped onto a plate (channel-equipped substrate and test plate for joint strength measurement) serving as a target substrate and was then scraped off using a Mayer bar of a designated number shown in Table 1 to perform coating with a specific applied amount. The coated plate was placed in an oven of a designated temperature and was dried to form a joining layer.

### (5-2. Measurement of surface roughness Ra)

The surface roughness Ra of the joining layer formed on the channel-equipped substrate was determined according to the previously described method. The results are shown in Table 1.

### [6. Production of laminate through joining of channel-equipped substrate and cover material]

### (6-1. Production of laminate for external appearance evaluation and evaluation of external appearance)

The channel-equipped substrate on which the joining layer had been formed and the cover material were stacked and temporarily fixed in an orientation such as to be in contact via the joining layer and were then subjected to vacuum packaging in a retort packaging material using a vacuum packaging machine (T100 produced by Nippon Hoso-Kikai Co., Ltd.). The vacuum package was then loaded into an autoclave (DANDELION DL-2010 produced by Hanyuda Co., Ltd.) and was subjected to heating and pressing under designated conditions. Once the autoclaving was complete, the vacuum package was cooled to room temperature, the laminate was removed, and external appearance was evaluated. The results are shown in Table 1.

### (6-2. Production of joined product for joint strength measurement and measurement of joint strength)

A test plate 21 for joint strength measurement on which a joining layer had been formed and a test plate 21 for joint strength measurement that had not been coated were stacked and temporarily fixed in an orientation such as to be in contact via a joining agent 13 at an overlap margin 22 (joining layer formation region) up to 5 mm from the end of a short side thereof, and were then vacuum packaged in a retort packaging material. The vacuum package was loaded into an autoclave (DANDELION DL-2010 produced by Hanyuda Co., Ltd.) and was subjected to heating and pressing under designated conditions. Once the autoclaving was complete, the vacuum package was cooled to room temperature, a joined product 20 for joint strength measurement was removed, and joint strength was measured by the previously described method. The results are shown in Table 1.

[Table 1]

| | | | Example 1 | Example 2 | Example 3 | Example 4 | Comparative Example 1 | Comparative Example 2 | Comparative Example 3 |
|---|---|---|---|---|---|---|---|---|---|
| Manufacturing conditions | Joining agent mixing ratio (wt%) | COP-3 | 12 | 3 | 7.5 | 12 | 0 | 15 | 1 |
| | | COP-4 | 3 | 12 | 7.5 | 3 | 15 | 0 | 4 |
| | | Cyclohexane | 85 | 0 | 85 | 85 | 85 | 85 | 95 |
| | | Xylene | 0 | 85 | 0 | 0 | 0 | 0 | 0 |
| | Joining agent Tg (°C) | | 84 | 122 | 102 | 84 | 138 | 68 | 122 |
| | Substrate (Tg) | | COP-1 (Tg = 136°C) | COP-2 (Tg = 163°C) | COP-1 (Tg = 136°C) | COP-1 (Tg = 136°C) | COP-1 (Tg = 136°C) | COP-1 (Tg = 136°C) | COP-1 (Tg = 136°C) |
| | Cover material (Tg) | | COP-1 (Tg = 136°C) | COP-2 (Tg = 163°C) | COP-2 (Tg = 163°C) | COP-1 (Tg = 136°C) | COP-1 (Tg = 136°C) | COP-1 (Tg = 136°C) | COP-1 (Tg = 136°C) |
| | Screen mesh specifications | Material | Stainless steel | Stainless steel | Stainless steel | Nylon | Stainless steel | - | - |
| | | Mesh count/inch | 500 | 500 | 500 | 250 | 500 | - | - |
| | | Thread diameter (µM) | 18 | 18 | 18 | 30 | 18 | - | - |
| | Mayer bar no. | | - | - | - | - | - | No. 16 | No. 16 |
| | Drying conditions (°C/min) | | 110/30 | 150/30 | 120/30 | 110/30 | 100/30 | 100/30 | 150/30 |
| | Application thickness (µm) | | 3 | 3 | 3 | 3 | 3 | 5 | 1.5 |
| | Autoclave conditions (°C/MPa/hr) | | 120/0.8 MPa/60 | 140108 MPa/60 | 120/0.8 MPa/60 | 120108 MPa/60 | 150/0.8 MPa/60 | 120/0.8 MPa/60 | 130/0.8 MPa/60 |
| Evaluations | Surface roughness Ra (µm) | | 0.269 | 0.276 | 0.272 | 0.603 | 0.305 | 0.907 | 003 |
| | External appearance | | OK | OK | OK | OK | Poor (substrate deformation) | Poor (unevenness) | Poor (looseness) |
| | Joint strength (N) | 25°C | 161.5 (breaking) | 160.1 (breaking) | 157.5 (breaking) | 159.5 (breaking) | Not measurable due to deformation | 164.2 (breaking) | 26.4 (peeling) |
| | | 80°C | 155.2 (breaking) | 157.4 (breaking) | 154.2 (breaking) | 152.2 (breaking) | Not measurable due to deformation | 38.4 (peeling) | 12.4 (peeling) |

The results shown in Table 1 demonstrate that the presently disclosed laminate maintains good joint strength and displays good external appearance.

### INDUSTRIAL APPLICABILITY

According to the present disclosure, it is possible to provide a laminate that can be used as a microchannel chip that maintains joint strength while also displaying good external appearance and having reduced risk of liquid leakage from a channel and also to provide a method for manufacturing the same.

### REFERENCE SIGNS LIST

- 10: laminate
- 11: channel-equipped substrate
- 12: cover material
- 13: joining agent
- 14: channel
- 15: injection/discharge through hole
- 16a: knock pin
- 16b: ejector pin position
- 17: channel terminal
- 20: joined product for joint strength measurement
- 21: test plate for joint strength measurement
- 22: overlap margin
- 30: silk screen printing machine
- 31: mesh screen
- 32: squeegee
- 40: material tester
- 41: supporting point
- 42: pressing jig

## Claims

1. A laminate comprising:
a channel-equipped substrate having a cycloolefin polymer as a material; and
a cover material having a cycloolefin polymer as a material that are joined via a joining agent having a mixture of two or more cycloolefin polymers as a material,
wherein a glass-transition temperature of the mixture of cycloolefin polymers that is a material of the joining agent is not less than 20°C lower than both a glass-transition temperature of the cycloolefin polymer that is a material of the channel-equipped substrate and a glass-transition temperature of the cycloolefin polymer that is a material of the cover material, and
wherein the glass-transition temperature of the mixture of cycloolefin polymers that is a material of the joining agent is not lower than 68°C and not higher than 138°C.

2. A method for manufacturing the laminate according to claim 1, comprising:
depositing a joining agent selectively in a specific region of either or both of a joining surface of a channel-equipped substrate and a joining surface of a cover material such as to have an uneven shape with an average roughness Ra of not less than 0.05 µm and not more than 0.80 µm; and
joining the channel-equipped substrate and the cover material via the joining agent that has been deposited.

3. The method according to claim 2, wherein, in the depositing of the joining agent, the joining agent is deposited on either or both of one surface of the channel-equipped substrate and one surface of the cover material by silk screen printing.
